# EUROPEAN PATENT APPLICATION

(11) **EP 4 345 914 A1**
(43) Date of publication of application: **03.04.2024**
(21) Application number: 22928257.9
(22) Date of filing: 27.10.2022
(51) Int. Cl.: H01L 31/0224

(54) **HETEROJUNCTION CELL, AND PHOTOVOLTAIC MODULE CELL STRING AND MANUFACTURING METHOD THEREFOR**

(30) Priority: 25.02.2022 CN 202210182215
(71) Applicant: TONGWEI SOLAR (HEFEI) CO., LTD., Hefei, Anhui 230088 (CN)
(72) Inventor: ZHANG, Zhixun, Hefei, Anhui 230088 (CN); ZHOU, Huaming, Hefei, Anhui 230088 (CN); SHI, Gang, Hefei, Anhui 230088 (CN)
(74) Representative: Marks & Clerk LLP
(86) International application number: PCT/CN2022/127990
(87) International publication number: WO 2023/159995

(57) **Abstract**

The present application relates to a heterojunction cell (100), and a photovoltaic module cell string and a manufacturing method therefor. The heterojunction cell (100) comprises: a cell sheet (10), the cell sheet (10) being provided with a front face and a back face, which are arranged opposite each other; screen-printed grid lines (20), the screen-printed grid lines (20) being made of silver paste and being arranged on the front face and the back face of the cell sheet (10); and a metal mesh (30), the metal mesh (30) being connected to the screen-printed gate lines (20) and being fixedly arranged on the cell sheet (10).

## Description

### CROSS-REFERENCE TO RELATED APPLICATIONS

The present disclosure claims priority of Chinese Patent Application No. 2022101822154, filed on February 25, 2022, entitled "HETEROJUNCTION CELL, AND PHOTOVOLTAIC MODULE CELL STRING AND MANUFACTURING METHOD THEREFOR", the entire content of which is incorporated herein in its entirety.

### TECHNICAL FIELD

The present disclosure relates to the technical field of cells, and in particular to a heterojunction cell, a photovoltaic assembly cell string and a manufacturing method therefor.

### BACKGROUND

Faced with the serious problem of depletion of non-renewable energy worldwide, countries are vigorously advocating the development of renewable clean energy. Among them, the photovoltaic industry that can convert solar energy into electrical energy has received unprecedented development opportunities.

The core component of photovoltaic modules is photovoltaic cells. Currently, heterojunction cells in the industry mainly use SmartWire smart grid connection technology (SWCT) or similar technologies for packaging. Such technologies require the use of composite films to bind low-temperature metals during string welding. After lamination and hot-pressing processing, the low-temperature metal wire is connected to a silver grid line or ITO (indium tin oxide) to achieve electrical transmission. However, this type of technology has the following problems: the use cost of the composite film is high, and the light transmittance of the composite film is low, the long-term weather resistance is poor, the contact resistance between the metal wire and ITO is high, the packaging loss is large, and the efficiency of the photovoltaic cell is low.

### SUMMARY

In view of this, it is necessary to provide a heterojunction cell, a photovoltaic assembly cell string, and a manufacturing method thereof to address the problems of low cost, low light transmittance, poor weather resistance, high resistance and low cell efficiency of a composite film in the prior art.

On one aspect, the present disclosure provides a heterojunction cell, which includes:
a cell sheet having a front side and a rear side opposite to each other;
screen-printed grid lines configured as silver paste and provided on the front side and rear side of the cell sheet; and
a metal mesh connected to the screen-printed grid lines and fixed on the cell sheet, the metal mesh including a plurality of first metal wires and a plurality of second metal wires, the plurality of first metal wires being spaced apart along a first direction of the cell sheet, and the plurality of second metal wires being spaced apart along a second direction of the cell sheet, the first metal wires perpendicularly intersecting with the second metal wires, the first metal wires being configured as main grid lines, and the second metal wires being configured as auxiliary grid lines.

When processing the heterojunction cell of the above solution, the screen-printed grid lines are firstly manufactured on the front side and rear side of the cell sheet sequentially using screen-printing according to the cell pattern, then the metal mesh prepared in advance is aligned with the screen-printed grid lines and laid on cell sheet, so that the metal mesh is bonded to the screen-printed grid lines. Finally, the cell sheet is placed in a drying equipment for drying and curing, such that the metal mesh can be bonded to the cell sheet as a whole through the screen-printed grid lines, so as to obtain the finished product of the heterojunction cell. In this way, the metal mesh can serve as a main grid line and an auxiliary grid line for current transmission. In addition to collecting current, the screen-printed grid line is mainly configured to bond and fix the metal mesh, which can greatly reduce the using amount of silver paste, reduce costs, while having high light transmittance and good weather resistance. In addition, a wire diameter of the metal mesh can be increased, and the conductivity is excellent, which helps to improve the efficiency of cell sheet.

The technical solution of the present disclosure is further described below.

In one embodiment, the screen-printed grid lines are configured as silver paste wires, a width of the silver paste wire ranges from 1µm to 50µm, a height of the silver paste wires range from 1µm to 20µm, and the silver paste wire has a width of 30µm and a height of 5µm.

In one embodiment, the screen-printed grid lines and the metal mesh have the same structure, such that the screen-printed grid lines are in full contact with and attached to the metal mesh.

In one embodiment, a distribution area of the screen-printed grid lines on the cell sheet is less than a distribution area of the metal mesh on the cell sheet, such that the screen-printed grid lines are in partial contact with and attached to the metal mesh.

In one embodiment, the metal mesh is any one of copper mesh, aluminum mesh, and alloy mesh.

In one embodiment, a wire diameter of the main grid line is greater than or equal to a wire diameter of the auxiliary grid line.

In one embodiment, the main grid line has a connecting wire segment, and the connecting wire segment extends to one side or two opposite sides of the cell sheet.

In one embodiment, the auxiliary grid line has a connecting wire segment, and the connecting wire segment extends to one side or two opposite sides of the cell sheet.

On another aspect, the present disclosure further provides a photovoltaic assembly cell string, which includes at least two heterojunction cells as described above, and the at least two the heterojunction cells are connected into a string in a shingled manner or a welding strip manner.

In addition, the present disclosure further provides a manufacturing method for processing the photovoltaic assembly cell string as described above, which includes the following steps:
providing a cell sheet, and screen-printing screen-print grid lines on the cell sheet according to a cell pattern;
aligning a metal mesh with the screen-printed grid lines and laying the metal mesh on the cell sheet;
drying and curing the cell sheet to form a heterojunction cell;
testing and grading the heterojunction cell;
performing a string welding process on at least two graded heterojunction cells to form a photovoltaic assembly cell string; and
stacking at least two photovoltaic assembly cell strings.

Details of one or more embodiments of the present disclosure are set forth in the following drawings and descriptions. These and other objects, purposes and advantages will become apparent upon review of the following specification, drawings and claims.

### BRIEF DESCRIPTION OF THE DRAWINGS

To better describe and illustrate embodiments and/or examples of the present disclosure, reference may be made to one or more of the accompanying drawings. The additional details or examples used to describe the drawings should not be construed as limiting the scope of any of the disclosed disclosures, the embodiments and/or examples presently described, and the best modes currently understood of these disclosures.
FIG. 1 is an assembly view of a heterojunction cell according to some embodiments of the present disclosure.
FIG. 2 is an exploded view of FIG. 1.

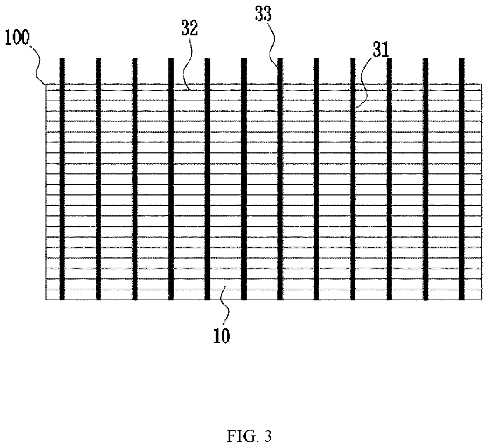

FIG. 3 is an assembly view of a heterojunction cell according to other embodiments of the present disclosure.

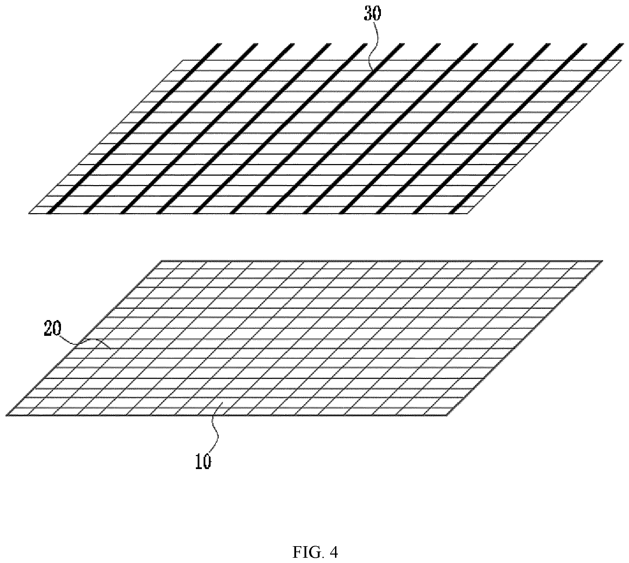

FIG. 4 is an exploded view of FIG. 3.

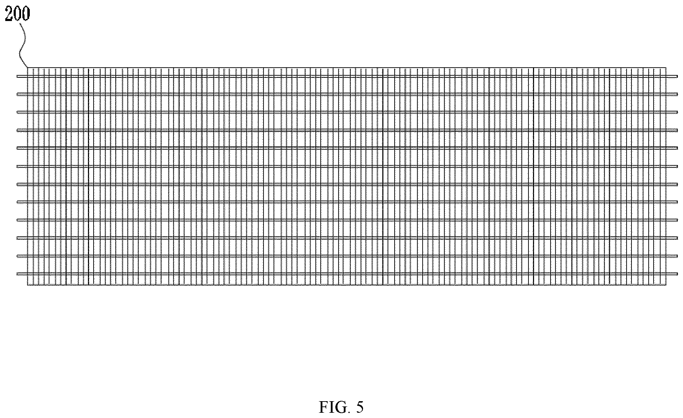

FIG. 5 is a schematic view of a photovoltaic assembly cell string according to some embodiments of the present disclosure.

### Description of reference signs:

100: heterojunction cell; 10: cell sheet; 20: screen-printed grid line;
30: metal mesh; 31: main grid line; 32: auxiliary grid line;
33: connecting wire segment; 200: photovoltaic assembly cell string.

### DETAILED DESCRIPTION OF THE EMBODIMENTS

In order to facilitate understanding of the present disclosure, the present disclosure will be described more comprehensively below with reference to the relevant drawings. The preferred embodiments of the present disclosure are shown in the accompanying drawings. However, the present disclosure may be implemented in many different forms and is not limited to the embodiments described herein. It should be understood that these embodiments are provided for the purpose of making the disclosure of the present disclosure more thorough and comprehensive.

In addition, the terms "first" and "second" are used for descriptive purposes only and cannot be understood as indicating or implying relative importance or implicitly indicating the number or order of indicated technical features. Therefore, features defined as "first" and "second" may explicitly or implicitly include at least one of these features. In the description of this disclosure, "plurality" means at least two, such as two, three, etc., unless otherwise expressly and specifically limited.

Unless otherwise defined, all technical and scientific terms used herein have the same meaning as commonly understood by those skilled in the technical field of the present disclosure. The terms used in the specification of the present disclosure herein are only for the purpose of describing specific embodiments, and are not intended to limit the present disclosure.

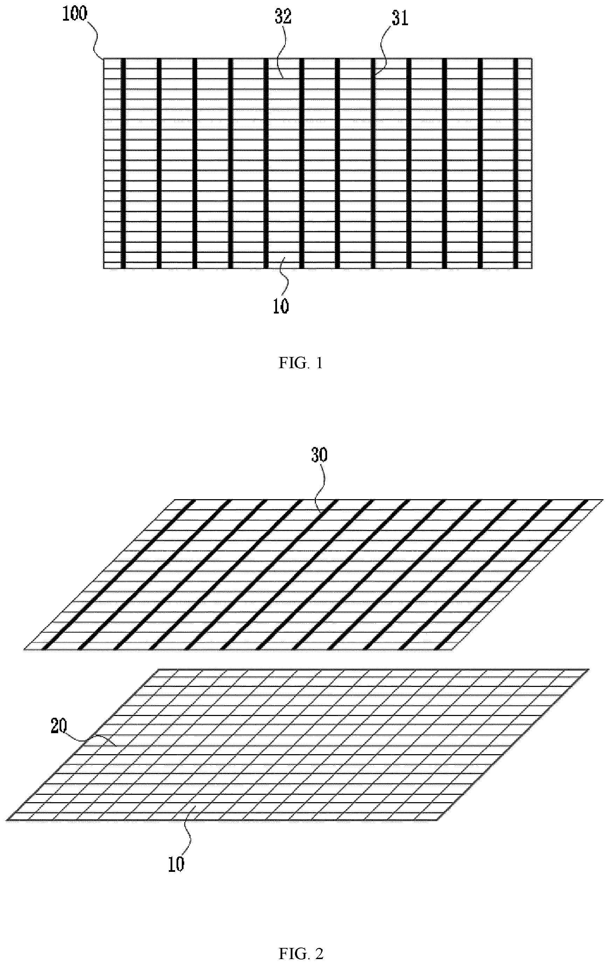

As shown in FIG. 1, a heterojunction cell 100 is provided according to some embodiments of the present disclosure. The English name of the heterojunction solar cell is HIT (Heterojunction with Intrinsic Thin-layer), and its Chinese name is intrinsic thin film heterojunction cell 100. A solar cell with a p-n junction composed of two different types of semiconductor materials can be called a heterojunction solar cell, as opposed to a homojunction cell, that is, the p-n junction is composed of the same semiconductor material. Good passivation contact can minimize a carrier load rate on a contact surface while maintaining good electrical performance of the cell. The heterojunction cell 100 structure is one of the best.

HIT cells generally use N-type silicon wafers as substrates, and has a typical structure that a transparent conductive oxide film (TCO for short), a P-type amorphous silicon thin film, and an intrinsic hydrogen-rich amorphous silicon thin film are sequentially arranged on a front side thereof, and a TCO transparent conductive oxide film, a N-type amorphous silicon thin film and an intrinsic amorphous silicon thin film are sequentially arranged on a rear side of the cell. The manufacturing process of HIT cell is also relatively simple. The thin films in the cell structure mentioned above are formed by deposition. Finally, metal electrodes are prepared on both sides of the cell through screen-printing or electroplating processes, and then a low temperature curing process is used to complete the manufacturing of the HIT cell. Compared with the conventional PERC cell production process and TOPCon cell process, the HIT cell process is relatively short, with only four major links, namely cleaning and texturing, amorphous silicon deposition, TCO deposition, and silk screen curing.
1. Cleaning and texturing is performed. Similar to the conventional P-type or N-type cell manufacturing process, cleaning and texturing is also a first step of manufacturing of the HIT cell. The main purpose of this step is to remove oil and metal impurities on a surface of a N-type substrate, remove a mechanical damage layer, form a pyramid texture, trap light and reduce surface reflection.
2. A amorphous silicon thin film is prepared. The silicon wafer is made into a passivation film and a PN junction in PECVD equipment. The root cause of the high efficiency of the HIT cell lies in the excellent passivation effect of the intrinsic amorphous silicon thin film. Since there are a large number of dangling bonds on a surface of the crystalline silicon substrate, the minority carriers excited by light reach the surface and are easily captured by the dangling bonds and recombine, thus reducing the cell efficiency. In addition, by depositing hydrogen-rich intrinsic amorphous silicon thin films on the front and back of the silicon wafer, the dangling bonds can be effectively hydrogenated and surface defects can be reduced, thereby significantly improving minority carrier lifetime, increasing open circuit voltage, and ultimately improving cell efficiency. Although a thickness of each layer of film is only 4nm to 10nm, the function and preparation process of each 1nm to 2nm are quite different. Therefore, the intrinsic and doped amorphous silicon thin films need to be completed in multiple chambers, and a multi-chamber deposition system need to be introduced in PECVD.
3. A metal oxide conductive layer (TCO) is deposited. After the amorphous silicon thin film is deposited on the silicon wafer, it enters SPUTTER (magnetron sputtering) or RPD (reactive ion coating) equipment to deposit a transparent metal oxide conductive film TCO. TCO collects the carriers longitudinally and transports the carriers to an electrode. Since the crystal of the amorphous silicon layer has a disordered structure, the mobility of electrons and holes is low, and the lateral conductivity is poor, which is not conducive to the collection of photogenerated carriers. Therefore, it is necessary to deposit a layer of TCO with a thickness of 75nm to 80nm above a front-side doping layer to collect the carriers longitudinally and transmit the carriers to the electrode. TCO can also reduce optical reflection.
4. Screen-printing and curing is performed. A final step in HIT cell production is screen-printing and curing, where metal electrodes are prepared and cured. Considering that HIT is a low-temperature process and does not distinguish between front silver and back silver, the process of screen-printing and low-temperature curing is relatively simple. However, one of the disadvantages of this feature is higher price and larger consumption. Therefore, currently, some enterprises in the industry also try to use copper plating process to make electrodes.

Compared with conventional technology, this solution provides the heterojunction cell 100 having a new structural composition. Specifically, in some embodiments, the heterojunction cell 100 includes a cell sheet 10, screen-printed grid lines 20, and a metal mesh 30.

The cell sheet 10 has a front side and a rear side opposite to each other. The screen-printed grid lines 20 are provided on the front side and the rear side of the cell sheet 10. The metal mesh 30 is connected to the screen-printed grid lines 20 and fixed on the cell sheet 10.

In some embodiments, the screen-printed grid lines 20 are configured as silver paste or conductive glue according to actual needs, which can improve the prepare-ability of the screen-printed grid lines 20. In order to facilitate the description of the technical solution, an example of processing the screen-printed grid lines 20 using silver paste will be described below.

In summary, implementing the technical solution of this embodiment will have the following beneficial effects: when processing the heterojunction cell 100 of the above solution, the screen-printed grid lines 20 are firstly manufactured on the front side and rear side of the cell sheet 10 sequentially using screen-printing according to the cell pattern, then the metal mesh 30 prepared in advance is aligned with the screen-printed grid lines 20 and laid on cell sheet 10, so that the metal mesh 30 is bonded to the silver paste. Finally, the cell sheet 10 is placed in a drying equipment for drying and curing. The metal mesh 30 can be bonded to the cell sheet 10 as a whole through the silver paste, and the above steps are repeated to prepare the other side, so as to obtain the finished product of the heterojunction cell 100.

In this way, the metal mesh 30 can serve as a main grid line 31 and an auxiliary grid line 32 for current transmission. In addition to collecting current, the screen-printed grid line 20 is mainly configured to bond and fix the metal mesh 30, which can greatly reduce the using amount of silver paste, reduce costs, while having high light transmittance and good weather resistance. In addition, a wire diameter of the metal mesh 30 can be increased, and the conductivity is excellent, which helps to improve the efficiency of cell sheet 10.

In some embodiments, the screen-printed grid lines 20 are configured as silver paste wires. A width of the silver paste wire ranges from 1µm to 50µm, and a height of the silver paste wire ranges from 1µm to 20µm. By arranging the silver paste wire of different widths and heights, the metal mesh 30 of different diameters can be used, so that the heterojunction cell 100 can obtain different cell efficiencies, thus improving the application range of the heterojunction cell 100.

For example, taking into account of processability, cost, cell efficiency and other factors, the silver paste wire with a width of 30µm and a height of 5µm can be selected.

In some embodiments, the screen-printed grid lines 20 and the metal mesh 30 have the same structure, such that the screen-printed grid lines 20 are in full contact with and attached to the metal mesh 30. In this way, a bonding area between the metal mesh 30 and the silk screen grid lines 20 is the largest, which helps to improve the bonding strength between the metal mesh 30 and the cell sheet 10, and to improve the structural stability of the heterojunction cell 100. For example, in some embodiments, the cell sheet 10 is rectangular, the metal mesh 30 has a rectangular grid structure with rectangular mesh holes, correspondingly, the screen-printed grid lines 20 also have a rectangular mesh structure with the same size and structure as the metal mesh 30. It should be understood that, each metal wire of the metal mesh 30 is in contact with and bonded to a corresponding screen-printed grid line 20.

Alternatively, in other embodiments, a distribution area of the screen-printed grid lines 20 on the cell sheet 10 is less than a distribution area of the metal mesh 30 on the cell sheet 10, such that the screen-printed grid lines 20 are in partial contact with and attached to the metal mesh 30. At this time, under the premise of ensuring the installation stability of the metal mesh 30, only a part of the metal mesh 30 can be allowed to be bonded to the screen-printed grid lines 20, which helps to further reduce the using amount of silver paste and achieve the purpose of reducing costs.

Optionally, the metal mesh 30 is any one of copper mesh, aluminum mesh, and alloy mesh. The metal mesh 30 is easy to obtain, easy to manufacture and has low cost of use, which can improve the manufacturability of the heterojunction cell 100. It should be noted that in actual processing, the metal mesh 30 may not be limited to the above materials, and may be selected according to actual needs.

In some embodiments, the metal mesh 30 includes a plurality of first metal wires and a plurality of second metal wires. The plurality of first metal wires are spaced apart along a first direction of the cell sheet 10, the plurality of second metal wires are spaced apart along a second direction of the cell sheet 10, and the first metal wires intersect the second metal wires perpendicularly. The first metal wires are configured as the main grid lines 31, while the second metal wires are configured as the auxiliary grid lines 32. The structure of the metal mesh 30 is simple, and the first metal wire and the second metal wire intersect perpendicularly to facilitate processing and forming. In addition, arranging multiple first metal wires and second metal wires at the same time helps to improve the current flow efficiency and improve the efficiency of the cell piece 10.

Certainly, it should be noted that in other embodiments, the metal mesh 30 may include only one type of metal wire, and the metal wire may be arranged in a regular or irregular structure such as a spiral shape or a loop shape. Alternatively, when the metal mesh 30 includes the first metal wire and the second metal wire, the first metal wire and the second metal wire are arranged in an intersecting or non-intersecting structure of a regular or irregular structure such as a spiral shape or a loop shape.

In some embodiments, a wire diameter of the main grid line 31 is greater than or equal to a wire diameter of the auxiliary grid line 32. For example, in this embodiment, the main grid line 31 is arranged vertically, the auxiliary grid line 32 is arranged horizontally, and the wire diameter of the main grid line 31 is greater than the wire diameter of the auxiliary grid line 32. At this time, the main grid line 31 has higher strength, which can support the auxiliary grid line 32 and ensure that the structure of the entire metal mesh 30 is more stable.

Furthermore, the main grid line 31 or the auxiliary grid line 32 has a connecting wire segment 33. The connecting wire segment 33 is used at both ends of a cell string and configured to be welded with a bus bar, and can also extend to one side or two opposite sides of the cell piece 10. When assembling a plurality of heterojunction cells 100, the extended connecting wire segment 33 facilitates welding or bonding of adjacent heterojunction cells 100 into one body.

It should be noted that when connected in a shingled manner, opposite sides of the two adjacent heterojunction cells 100 may not be provided with the connecting wire segment 33 extending out, and the two adjacent heterojunction cells 100 may be directly assembled in a manner of being partially stacked up and down and then bonded and fixed.

In addition to the above, the present disclosure further provides a photovoltaic assembly cell string 200, which includes at least two heterojunction cells 100 according to any of the above embodiments. The at least two heterojunction cells 100 are connected into a string in a shingled manner or a welding strip manner.

In addition, the present disclosure further provides a manufacturing method for processing the above photovoltaic assembly cell string 200, which includes the following steps.

S100: A cell sheet 10 is provided, and screen-printed grid lines 20 are screen-printed on the cell sheet 10 according to a cell pattern.

S200: A metal mesh 30 is aligned with the screen-printed grid lines 20 and then laid on the cell sheet 10.

S300: The cell sheet 10 is dried and cured to form a heterojunction cell 100.

S400: The heterojunction cell 100 is tested and graded.

S500: The at least two graded heterojunction cells 100 are subjected to a string welding process to form a photovoltaic assembly cell string 200.

S600: At least two photovoltaic assembly cell strings 200 are stacked.

The above-mentioned embodiments do not constitute a limitation on the protection scope of the technical solution. Any modifications, equivalent replacements and improvements made within the spirit and principles of the above-mentioned embodiments shall be included within the protection scope of this technical solution.

The foregoing descriptions are merely specific embodiments of the present disclosure, but are not intended to limit the protection scope of the present disclosure. Any variation or replacement readily figured out by a person skilled in the art within the technical scope disclosed in the present disclosure shall all fall within the protection scope of the present disclosure. The description and drawings can be used to interpret the claims.

## Claims

1. A heterojunction cell, comprising:
a cell sheet having a front side and a rear side opposite to each other;
screen-printed grid lines configured as silver paste and provided on the front side and rear side of the cell sheet; and
a metal mesh connected to the screen-printed grid lines and fixed on the cell sheet, the metal mesh comprising a plurality of first metal wires and a plurality of second metal wires, the plurality of first metal wires being spaced apart along a first direction of the cell sheet, the plurality of second metal wires being spaced apart along a second direction of the cell sheet, the first metal wires perpendicularly intersecting with the second metal wires, wherein the first metal wires are configured as main grid lines, and the second metal wires are configured as auxiliary grid lines.

2. The heterojunction cell according to claim 1, wherein the screen-printed grid lines are configured as silver paste wires, a width of the silver paste wire ranges from 1µm to 50µm, a height of the silver paste wires range from 1µm to 20µm, and the silver paste wire has a width of 30µm and a height of 5µm.

3. The heterojunction cell according to claim 2, wherein the screen-printed grid lines and the metal mesh have the same structure, such that the screen-printed grid lines are in full contact with and attached to the metal mesh.

4. The heterojunction cell according to claim 2, wherein a distribution area of the screen-printed grid lines on the cell sheet is less than a distribution area of the metal mesh on the cell sheet, such that the screen-printed grid lines are in partial contact with and attached to the metal mesh.

5. The heterojunction cell according to any one of claims 2 to 4, wherein the metal mesh is any one of copper mesh, aluminum mesh, and alloy mesh.

6. The heterojunction cell according to claim 5, wherein a wire diameter of the main grid line is greater than or equal to a wire diameter of the auxiliary grid line.

7. The heterojunction cell according to claim 6, wherein the main grid line has a connecting wire segment, and the connecting wire segment extends to one side or two opposite sides of the cell sheet.

8. The heterojunction cell according to claim 6, wherein the auxiliary grid line has a connecting wire segment, and the connecting wire segment extends to one side or two opposite sides of the cell sheet.

9. A photovoltaic assembly cell string, comprising at least two heterojunction cells according to any one of the claims 1 to 8, and the at least two heterojunction cells are connected into a string in a shingled manner or a welding strip manner.

10. A manufacturing method for processing the photovoltaic assembly cell string according to claim 9, comprising the following steps:
providing a cell sheet, and screen-printing screen-print grid lines on the cell sheet according to a cell pattern;
aligning a metal mesh with the screen-printed grid lines and laying the metal mesh on the cell sheet;
drying and curing the cell sheet to form a heterojunction cell;
testing and grading the heterojunction cell;
performing a string welding process on at least two graded heterojunction cells to form a photovoltaic assembly cell string; and
stacking at least two photovoltaic assembly cell strings.
